# EUROPÄISCHE PATENTSCHRIFT

(11) **EP 3 895 507 B1**
(45) Veröffentlichungstag und Bekanntmachung des Hinweises auf die Patenterteilung: **24.04.2024**
(21) Anmeldenummer: 19818050.7
(22) Anmeldetag: 10.12.2019
(51) Int. Cl.: H05K 1/02, B62D 15/02, H05K 1/16, F16H 55/17

(54) **ELEKTRONISCHE LEITERPLATTE**
ELECTRONIC PRINTED CIRCUIT BOARD
CARTE DE CIRCUIT IMPRIMÉ ÉLÉCTRONIQUE

(30) Priorität: 13.12.2018 DE 102018132098
(43) Veröffentlichungstag der Anmeldung: 20.10.2021
(73) Patentinhaber: thyssenkrupp Presta AG, 9492 Eschen (LI); thyssenkrupp AG, 45143 Essen (DE)
(72) Erfinder: GALEHR, Robert, 9486 Schaanwald (LI); RACZ, Gergely, 1115 Budapest (HU); SEN, Sedat, 9435 Heerbrugg (CH)
(74) Vertreter: thyssenkrupp Intellectual Property GmbH
(86) Internationale Anmeldenummer: PCT/EP2019/084426
(87) Internationale Veröffentlichungsnummer: WO 2020/120476

(56) Entgegenhaltungen:
- EP-A1- 3 190 384
- DE-A1-102015 202 732
- US-A- 4 734 825
- US-A- 6 111 378
- US-A1- 2002 153 419

## Beschreibung

Die vorliegende Erfindung betrifft eine Leiterplatte mit den Merkmalen des Oberbegriffs des Anspruchs 1 und ein Verfahren zur Herstellung einer solchen Leiterplatte.

Eine Leiterplatte ist ein Träger für elektronische Bauteile. Sie dient der mechanischen Befestigung und der mechanischen Verbindung von elektronischen Bauteilen. Leiterplatten bestehen aus elektrisch isolierendem Material, insbesondere faserverstärktem Kunststoff mit daran haftenden, leitenden Verbindungen, die sogenannten Leiterbahnen.

Aus der Offenlegungsschrift EP 2 247 925 A1 sind Leiterplatten bekannt, welche Teil einer Lenkwinkelsensoranordnung sind. Dabei ist eine Leiterplatte mit einem Zahnrad verbunden, das sich an einem zweiten Zahnrad abwälzt, um damit einen Lenkwinkel einer Welle zu bestimmen.

Aus der US 4,734,825 A, die das Stapeln von integrierten Schaltungen betrifft, ist zudem bekannt, eine Leiterplatte mit einer Oberseite, einer Unterseite und einer Umfangsfläche so auszugestalten, dass die Umfangsfläche eine Verzahnung aufweist, wobei die Zähne als leitende Kontakte ausgebildet sind. Weiter ist auch aus der US 2002/0153419 A1, die eine gegen Umwelteinflüsse abgedichtete modulare Computerplattform betrifft, eine Hauptplatine bekannt, die ebenfalls eine Verzahnung aufweist, um über die Zähne elektrisch leitfähige Kontaktierungsstellen bereitzustellen. Aus der US 6,111,378 A ist zudem ein Scheibenwischermotor-System bekannt, wobei ein Zahnrad des Systems eine integrierte Schaltung aufweist.

Die Schrift DE 10 2008 011 448 A1 offenbart eine Lenkwelle, deren Drehung mit zwei Zahnradgetrieben abgetastet wird, wobei ein erstes Zahnradgetriebe ein Hypozykloidgetriebe ist, welches mit einer Leiterplatte verbunden ist, und mit dem über mehrere Umläufe ein absoluter Winkelwert bestimmt werden kann. Zur Verbesserung der Winkelauflösung wird ein zweites Zahnradgetriebe eingesetzt, das je Umdrehung der Lenkwelle an einen Satelliten eine Vielzahl von Drehungen überträgt, so dass ein genauer Winkel bestimmt werden kann. Durch die Kombination der beiden abgetasteten Winkelsignale wird eine Absolutwinkelbestimmung ermöglicht. Die vorgeschlagene Lösung erweist sich als nachteilig dahingehend, dass viele Bauteile und damit ein großer Bauraum benötigt wird.

Eine weitere Sensoranordnung zur Erfassung von Drehwinkeln an einem rotierenden Bauteil in einem Kraftfahrzeug wird in der DE 10 2015 202 732 A1 offenbart. Zudem ist aus der EP 3 190 384 A1 ein Trägheitsmessgerät mit einer Leiterplatte mit einem Trägheitssensor bekannt.

Es ist deshalb eine Aufgabe der vorliegenden Erfindung, eine Leiterplatte anzugeben, die eine einfache und verbesserte Sensoreinheit ermöglicht.

Diese Aufgabe wird von einer Leiterplatte mit den Merkmalen des Anspruchs 1 und einem Verfahren zur Herstellung einer Leiterplatte mit den Merkmalen des Anspruchs 12 gelöst. Vorteilhafte Weiterbildungen ergeben sich aus den Unteransprüchen.

Demnach ist eine Leiterplatte aufweisend eine Oberseite, eine Unterseite und eine Umfangsfläche, die die Oberseite mit der Unterseite verbindet vorgesehen, wobei die Umfangsfläche eine Verzahnung zur Ausbildung eines Zahnrades aufweist.

Die Leiterplatte mit der Verzahnung bildet somit unmittelbar das Zahnrad aus. Da die Verzahnung einstückig mit der Leiterplatte ausgebildet ist, können Bauteile und/oder weitere Verarbeitungsschritte eingespart werden.

Vorzugsweise ist die Verzahnung umfangsgeschlossen und über die gesamte Fläche der Umfangsfläche ausgebildet. Die Verzahnung kann auf der Außenumfangsfläche oder der Innenumfangsfläche ausgebildet sein. Die Leiterplatte ist bevorzugt kreisrund.

Die Verzahnung ist vorzugsweise als eine evolvente, epizykloide oder hypozykloide Verzahnung oder als Triebstockverzahnung ausgebildet. Die Verzahnung kann achsparallel, schräg oder als Bogenverzahnung ausgestaltet sein. Weiterhin ist es denkbar und möglich, dass die Zähne als Malteserkreuz ausgebildet sind.

Erfindungsgemäß trägt die Leiterplatte eine Spur und/oder Oberflächenstruktur und/oder eine Leiterbahn, die zur induktiven und/oder kapazitiven und/oder optischen und/oder akustischen Abtastung ausgebildet ist. Die Spuren und/oder die Oberflächenstruktur sind vorzugsweise aus Kupfer gebildet. Weiterhin ist es denkbar und möglich, dass diese aus Aluminium, Silber, Zinn, Nickel und/oder Gold gebildet sind. Die Spur ist vorzugsweise kreisförmig und weist jeweils eine Breite in Radialrichtung, in der Ebene der Ober-/Unterseite der Zahnräder auf, die entlang des Kreisumfangs über einen ersten Halbkreis gleichmäßig zunimmt und über den zweiten Halbkreis wieder gleichmäßig abnimmt. Die Zuwachs- und Abnahmerate der Breite ist dabei jeweils stetig und konstant über den gesamten Umfang.

Die Leiterplatte ist ein Träger für elektronische Bauteile. Vorzugsweise weist die Leiterplatte wenigstens eines der folgenden Bauteile auf: wenigstens einen elektrischen Widerstand, wenigstens einen Kondensator, wenigstens eine Diode und/oder wenigstens einen Transistor.

Die Leiterplatte ist vorteilhafterweise aus faserverstärktem Kunststoff hergestellt.

Es kann vorgesehen sein, dass das Zahnrad und/oder die Verzahnung eine zuvor genannte Oberflächenstruktur aufweist.

Die Spur und oder die Oberflächenstruktur kann durch Vorsprünge und Vertiefungen ausgebildet sein.

Es ist bevorzugt, wenn die Leiterplatte oder die Verzahnung mit einer Beschichtung versehen ist, welche wenigstens MoSz, PTFE, Grafit oder PE-UHMW enthält. Denkbar und möglich ist, dass die Beschichtung als Lack ausgebildet ist.

Weiterhin ist eine Sensoreinheit aufweisend wenigstens eine zuvor beschriebene Leiterplatte vorgesehen. Die Sensoreinheit ist bevorzugt zur Messung eines Drehzustands einer Welle vorgesehen, wobei sie bevorzugt ein mit der Welle verbundenes Getriebe aufweist, wobei das Getriebe wenigstens zwei Getriebeelemente aufweist, die über eine Verzahnung in Eingriff miteinander stehen und wobei wenigstens eines der wenigstens zwei Getriebeelemente ein Zahnrad ist, dessen Drehung um eine Drehachse von der Sensoreinheit detektiert wird, und wobei das wenigstens eine Zahnrad und die Verzahnung des wenigstens einen Zahnrades durch eine zuvor beschriebene Leiterplatte gebildet sind. Das Getriebe kann als Stirnradgetriebe ausgebildet sein, wobei eines der Getriebeelemente eine Außenverzahnung und das andere Getriebeelement eine Innenverzahnung umfasst, wobei das außenverzahnte Getriebeelement in das innenverzahnte Getriebeelement eingreift. Weiterhin können beide Getriebeelemente als Außenverzahnung ausgebildet sein, über welche beide Getriebeelemente miteinander in Wirkverbindung stehen. Dadurch kann ein Zahnradgetriebe, ein Kronenradgetriebe, ein Schneckenradgetriebe, ein Sternradgetriebe oder ein Ellipsenradgetriebe realisiert werden. Ist das Getriebe als Zahnradgetriebe ausgebildet, weist das erste Zahnrad bevorzugt mindestens 3-mal mehr Zähne auf als das zweite Zahnrad, weiter bevorzugt 4-mal mehr Zähne als das zweite Zahnrad. Die Verzahnung beider Zahnräder ist auf der entsprechenden Leiterplatte ausgebildet. Die beiden Zahnräder stehen daher in Anlage mittels der Leiterplatten. Es ist weiterhin denkbar und möglich, die Sensoreinheit linear auszubilden in Form eines Zahnstangengetriebes, bei dem sich ein als Leiterplatte ausgebildetes Zahnrad auf einer Verzahnung einer Zahnstange abwälzt und somit die Drehung der Zahnstange in eine lineare Bewegung der Zahnstange und vice versa umgewandelt werden kann. Die Sensoreinheit umfasst vorteilhafterweise wenigstens eine Spule, die der wenigstens einen Leiterplatte zugewiesen werden kann und die die Spur und/oder die Oberflächenstruktur abtastet. Bevorzugt ist die wenigstens eine Spule Teil eines Schwingkreises und erzeugt ein hochfrequentes Magnetfeld. Die Sensoreinheit kann als Kraftfahrzeug-Sensoreinheit oder entsprechende Kraftfahrzeuglenksystem-Sensoreinheit ausgebildet sein.

Zudem ist ein Verfahren zur Herstellung einer zuvor genannten Leiterplatte aufweisend eine Oberseite, eine Unterseite und eine Umfangsfläche, die die Oberseite mit der Unterseite verbindet, vorgesehen, wobei das Verfahren folgenden Schritt aufweist:
- Ausbilden einer Verzahnung auf der Umfangsfläche der Leiterplatte mittels Fräsen, Stanzen oder Laserschneiden.

Dabei ist es bevorzugt, wenn die Verzahnung umfangsgeschlossen und über die gesamte Fläche der Umfangsfläche ausgebildet ist. Die Verzahnung kann auf der Innen- oder Außenumfangsfläche angeordnet sein.

Die Verzahnung ist bevorzugt als eine evolvente, epizykloide oder hypozykloide Verzahnung oder als Triebstockverzahnung, insbesondere als Malteserkreuz ausgebildet.

Bevorzugte Ausführungsformen der Erfindung werden nachfolgend anhand der Zeichnungen näher erläutert. Gleiche bzw. funktionsgleiche Bauteile sind dabei figurübergreifend mit denselben Bezugszeichen versehen. Es zeigen:
- Fig. 1:: eine räumliche Ansicht einer Leiterplatte,
- Fig. 2:: eine schematische Darstellung einer Sensoreinheit,
- Fig. 3:: eine Draufsicht auf eine Leiterplatte,
- Fig. 4:: eine Draufsicht auf eine Leiterplatte mit zusätzlicher Oberflächenstruktur,
- Fig. 5:: eine Detailansicht einer Verzahnung einer Leiterplatte,
- Fig. 6:: eine Detailansicht einer weiteren Verzahnung einer Leiterplatte,
- Fig. 7:: eine schematische Darstellung eines Zahnstangengetriebes mit verzahnter Leiterplatte, sowie
- Fig.8:: eine Seitenansicht der Leiterplatte aus Figur 1.

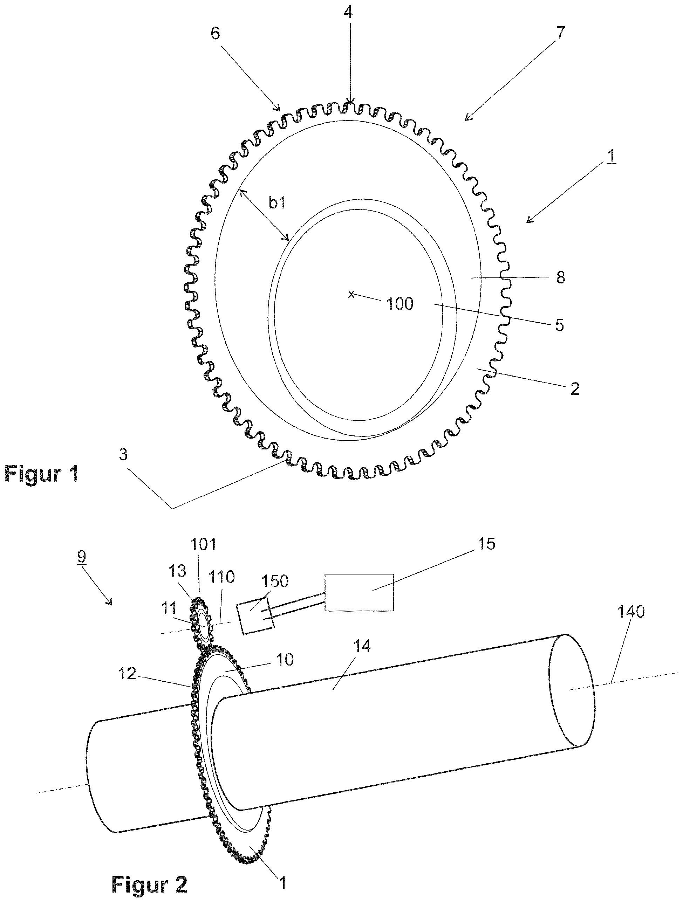

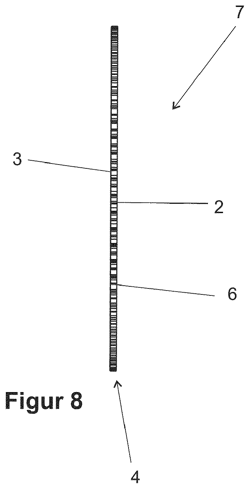

Die Figuren 1 und 8 zeigen eine Leiterplatte 1, die Teil einer Sensoreinheit ist. Die Leiterplatte 1 weist eine Oberseite 2, eine Unterseite 3 und eine Umfangsfläche 4 auf, wobei die Umfangsfläche 4 die Oberseite 2 mit der Unterseite 3 verbindet. Die Umfangsfläche 4 liegt auf der Außenseite und bildet eine Außenumfangsfläche aus. Die Leiterplatte 1 ist kreisrund ausgebildet. Sie weist eine dezentrale kreisrunde Öffnung 5 auf. Die Außenumfangsfläche 4 trägt über den gesamten Umfang eine Verzahnung 6 zur Ausbildung eines Zahnrades 7. Die Außenverzahnung 6 der Leiterplatte 1 wird mittels Fräsen, Stanzen Laserschneiden oder Ultraschallschneiden realisiert. Auf der Oberfläche der Ober- und/oder Unterseite 2,3 der Leiterplatte 1 ist eine Spur 8 aufgebracht. Die Spur 8 ist in sich geschlossen und weist keinen Anfang und kein Ende auf. Das Muster beziehungsweise die Oberflächenstruktur der Spur 8 ist nicht konzentrisch zu einer Drehachse 100 des Zahnrades 7 ausgebildet. Die Spur 8 ist kreisförmig und weist eine Breite b1 in Radialrichtung, in der Ebene der Oberseite 2 der Leiterplatte 1 auf, die entlang des Kreisumfangs über einen ersten Halbkreis gleichmäßig zunimmt und über den zweiten Halbkreis wieder gleichmäßig abnimmt. Die Zuwachs- und Abnahmerate der Breite b1 ist dabei jeweils stetig und konstant über den gesamten Umfang. Der Mittelpunkt des Kreises der Spur 8 liegt nicht auf der Drehachse 100 des Zahnrades 7. Die Spur 8 oder die Oberflächenstruktur sind vorzugsweise aus Kupfer gebildet. Weiterhin ist es denkbar und möglich, dass diese aus Aluminium, Silber, Zinn, Nickel und/oder Gold gebildet sind. Die Spur 8 und/oder die Oberflächenstruktur wird induktiv, kapazitiv, optisch oder akustisch abgetastet.

Die Leiterplatte 1 weist weiterhin wenigstens eines der folgenden Bauteile auf: wenigstens einen elektrischen Widerstand, wenigstens einen Kondensator, wenigstens eine Diode und/oder wenigstens einen Transistor. Auf die Leiterplatte 1 wird die Spur 8, eine Oberflächenstruktur und/oder eine Leiterbahn aufgebracht. Die Leiterplatte 1 besteht bevorzugt aus faserverstärktem Kunststoff.

Figur 2 zeigt schematisch eine Sensoreinheit 9, die zwei Zahnräder 10,11 umfasst. Die Zahnräder 10,11 bilden mit ihrer Außenverzahnung 12,13 die Leiterplatten 1,101. Ein erstes Zahnrad 10 ist mit einer Welle 14, insbesondere der Lenkwelle eines Kraftfahrzeuges, drehfest verbunden und umgibt diese konzentrisch. Das erste Zahnrad 10 weist eine nach außen gerichtete Verzahnung 12 auf, die konzentrisch zur Wellenachse 140 angeordnet ist. Diese erste Verzahnung 12 des ersten Zahnrades 10 greift in eine zweite umlaufende nach außen gerichtete Verzahnung 13 eines zweiten Zahnrads 11 ein, das sich auf dem ersten Zahnrad 10 abwälzt. Das zweite Zahnrad 11 dreht sich um eine zweite Zahnradachse 110, die parallel und versetzt zur Wellenachse 140 angeordnet und raumfest ist. Die Drehbewegung der Welle 14 wird somit auf das zweite Zahnrad 11 übertragen. Das erste und das zweite Zahnrad 10,11 sind ebenfalls durch Leiterplatten 1,101 ausgebildet.

Die Anzahl der Zähne des zweiten Zahnrades 11 ist kleiner als die Anzahl der Zähne des ersten Zahnrades 10. Die Anzahl der Zähne des ersten Zahnrades 10 ist kein ganzes Vielfaches der Anzahl der Zähne des zweiten Zahnrades 11. Dabei weist das erste Zahnrad 10 bevorzugt mindestens 3-mal mehr Zähne auf als das zweite Zahnrad 11, weiter bevorzugt 4-mal mehr Zähne als das zweite Zahnrad 11. Die Verzahnung 12,13 beider Zahnräder 10,11 ist auf der entsprechenden Leiterplatte ausgebildet. Die beiden Zahnräder 10,11 stehen daher in Anlage mittels der Leiterplatten.

Die Rotationen des ersten und des zweiten Zahnrades 10,11 werden mittels eines Sensors 150 gemessen und die Signale an eine Steuereinheit 15 weiter, die daraus einen absoluten Drehzustand, insbesondere einen Drehwinkel der Welle 14 bestimmen kann.

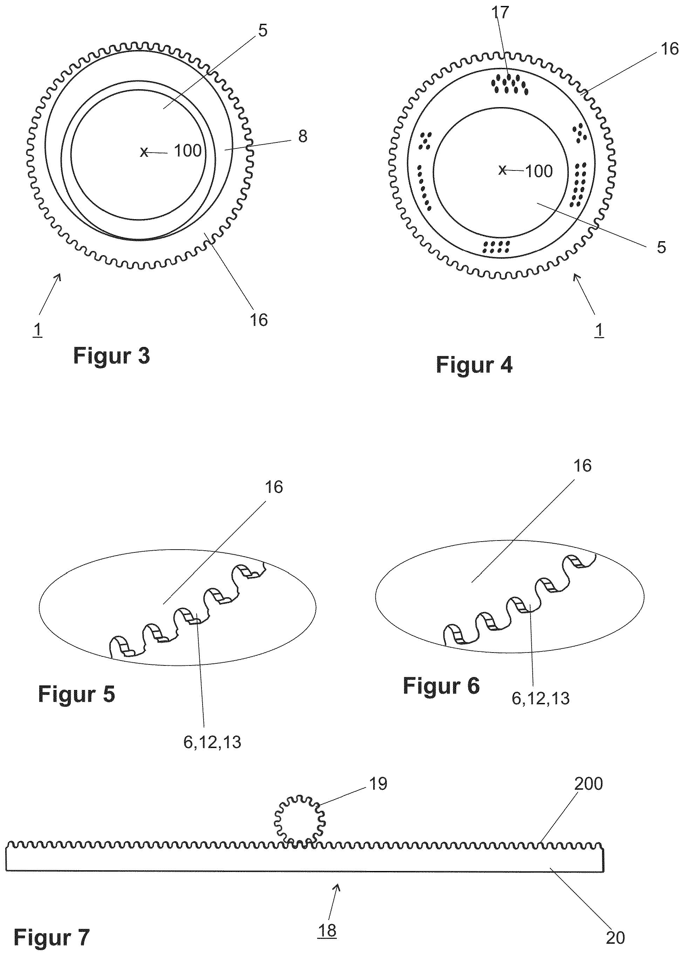

In der Figur 3 ist ein eine Leiterplatte ausbildendes Zahnrad 16 dargestellt. Das Zahnrad 16 trägt die zuvor beschriebene Spur 8. Beide Zahnräder der in Figur 2 dargestellten Sensoreinheit 9 sind bevorzugt so ausgebildet, um eine Absolutbestimmung des Drehwinkels der Welle 14 zu ermöglichen.

Figur 4 zeigt, dass das Zahnrad 16 zusätzlich zur Spur 8 eine Oberflächenstruktur 17 aufweisen können, mittels welcher der Drehzustand einer Welle genauer detektierbar ist.

In den Figuren 5 und 6 sind zwei exemplarische Verzahnungen eines als Leiterplatte ausgebildeten Zahnrades 7,10,11,16 dargestellt. Die Verzahnung kann, wie in Figur 5 dargestellt als Triebstockverzahnung oder als eine evolvente, epizykloide oder hypozykloide Verzahnung ausgebildet sein. Die Verzahnung kann achsparallel, schräg oder als Bogenverzahnung ausgestaltet sein. Weiterhin ist es denkbar und möglich, dass die Zähne als Malteserkreuz ausgebildet sind.

In der Figur 7 ist eine lineare Ausbildung der Sensoranordnung in Form eines Zahnstangengetriebes 18 dargestellt, bei dem sich ein als Leiterplatte ausgebildetes Zahnrad 19 auf einer Verzahnung 200 einer Zahnstange 20 abwälzt und somit die Drehung des Zahnrades 19 in eine lineare Bewegung der Zahnstange und vice versa umgewandelt werden kann. Eine nicht dargestellte Sensoreinheit misst dabei die Drehung des Zahnrads 19.

## Patentansprüche

1. Leiterplatte (1,11) aufweisend eine Oberseite (2), eine Unterseite (3) und eine Umfangsfläche (4), die die Oberseite (2) mit der Unterseite (3) verbindet, wobei die Umfangsfläche (4) eine Verzahnung (6,12,13) zur Ausbildung eines Zahnrades (7,10,11,16,19) aufweist, **dadurch gekennzeichnet, dass** eine Spur (8) und/oder Oberflächenstruktur (17) und/oder eine Leiterbahn zur induktiven und/oder kapazitiven und/oder optischen und/oder akustischen Abtastung ausgebildet ist.

2. Leiterplatte nach Anspruch 1, **dadurch gekennzeichnet, dass** die Verzahnung (6,12,13) umfangsgeschlossen und über die gesamte Fläche der Umfangsfläche (4) ausgebildet ist.

3. Leiterplatte nach Anspruch 1 oder 2, **dadurch gekennzeichnet, dass** die Verzahnung (6,12,13) als eine evolvente, epizykloide oder hypozykloide Verzahnung oder als Triebstockverzahnung ausgebildet ist.

4. Leiterplatte nach Anspruch 3, **dadurch gekennzeichnet, dass** das Zahnrad (7,10,11,16,19) als Malteserkreuz ausgebildet ist.

5. Leiterplatte nach einem der vorhergehenden Ansprüche, **dadurch gekennzeichnet, dass** die Leiterplatte (1,11) wenigstens eines der folgenden Bauteile aufweist: wenigstens einen elektrischen Widerstand, wenigstens einen Kondensator, wenigstens eine Diode und/oder wenigstens einen Transistor.

6. Leiterplatte nach einem der vorhergehenden Ansprüche, **dadurch gekennzeichnet, dass** die Leiterplatte (1,11) aus faserverstärktem Kunststoff hergestellt ist.

7. Leiterplatte nach einem der vorhergehenden Ansprüche, **dadurch gekennzeichnet, dass** das Zahnrad (7,10,11,16,19) und/oder die Verzahnung (6,12,13) eine Oberflächenstruktur aufweist.

8. Leiterplatte nach einem der vorhergehenden Ansprüche, **dadurch gekennzeichnet, dass** die Spur (8) und/oder die Oberflächenstruktur (17) durch Vorsprünge und Vertiefungen ausgebildet ist.

9. Leiterplatte nach einem der vorhergehenden Ansprüche, **dadurch gekennzeichnet, dass** die Leiterplatte (1,11) und/oder die Verzahnung (6,12,13) mit einer Beschichtung versehen, welche wenigstens MoSz, PTFE, Grafit oder PE-UHMW enthält.

10. Leiterplatte nach einem der vorhergehenden Ansprüche, **dadurch gekennzeichnet, dass** die Verzahnung (6,12,13) auf der Außenumfangsfläche ausgebildet ist.

11. Sensoreinheit aufweisend eine Leiterplatte (1,11) gemäß einem der vorhergehenden Ansprüche 1 bis 10.

12. Verfahren zur Herstellung einer Leiterplatte nach einem der Ansprüche 1 bis 10, wobei das Verfahren folgenden Schritt aufweist:
- Ausbilden einer Verzahnung auf der Umfangsfläche der Leiterplatte mittels Fräsen, Stanzen oder Laserschneiden.

13. Verfahren nach Anspruch 12, **dadurch gekennzeichnet, dass** die Verzahnung (6,12,13) umfangsgeschlossen über die gesamte Fläche der Umfangsfläche (4) ausgebildet ist.

14. Verfahren nach Anspruch 12 oder 13, **dadurch gekennzeichnet, dass** die Verzahnung (6,12,13) als eine evolvente, epizykloide oder hypozykloide Verzahnung oder als Triebstockverzahnung ausgebildet ist.

## Claims

1. A printed circuit board (1, 11) having a top side (2), a bottom side (3) and a circumferential surface (4) which connects the top side (2) to the bottom side (3), wherein the circumferential surface (4) has a toothing (6, 12, 13) for forming a gear wheel (7, 10, 11, 16, 19), **characterized in that** a track (8) and/or a surface structure (17) and/or a conductor track are/is designed for inductive and/or capacitive and/or optical and/or acoustic sampling.

2. The printed circuit board as claimed in claim 1, **characterized in that** the toothing (6, 12, 13) is circumferentially closed and formed over the entire surface area of the circumferential surface (4).

3. The printed circuit board as claimed in claim 1 or 2, **characterized in that** the toothing (6, 12, 13) is designed as an involute, epicycloid or hypocycloid toothing or as a lantern gear toothing.

4. The printed circuit board as claimed in claim 3, **characterized in that** the gear wheel (7, 10, 11, 16, 19) is designed as a Maltese cross.

5. The printed circuit board as claimed in one of the preceding claims, **characterized in that** the printed circuit board (1, 11) has at least one of the following components: at least one electrical resistor, at least one capacitor, at least one diode and/or at least one transistor.

6. The printed circuit board as claimed in one of the preceding claims, **characterized in that** the printed circuit board (1, 11) is produced from fiber-reinforced plastic.

7. The printed circuit board as claimed in one of the preceding claims, **characterized in that** the gear wheel (7, 10, 11, 16, 19) and/or the toothing (6, 12, 13) have/has a surface structure.

8. The printed circuit board as claimed in one of the preceding claims, **characterized in that** the track (8) and/or the surface structure (17) are/is formed by projections and recesses.

9. The printed circuit board as claimed in one of the preceding claims, **characterized in that** the printed circuit board (1, 11) and/or the toothing (6, 12, 13) are provided with a coating which contains at least MoS₂, PTFE, graphite or UHMWPE.

10. The printed circuit board as claimed in one of the preceding claims, **characterized in that** the toothing (6, 12, 13) is formed on the outer circumferential surface .

11. A sensor unit having a printed circuit board (1, 11) as claimed in one of preceding claims 1 to 10.

12. A method for producing a printed circuit board as claimed in one of claims 1 to 10, wherein the method comprises the following step:
- forming a toothing on the circumferential surface of the printed circuit board by means of milling, punching or laser cutting.

13. The method as claimed in claim 12, **characterized in that** the toothing (6, 12, 13) is formed circumferentially closed over the entire surface area of the circumferential surface (4).

14. The method as claimed in claim 12 or 13, **characterized in that** the toothing (6, 12, 13) is designed as an involute, epicycloid or hypocycloid toothing or as a lantern gear toothing.

## Revendications

1. Un circuit imprimé (1, 11) ayant une face supérieure (2), une face inférieure (3) et une surface circonférentielle (4) qui relie la face supérieure (2) à la face inférieure (3), dans laquelle la surface circonférentielle (4) a une denture (6, 12, 13) pour former une roue dentée (7, 10, 11, 16, 19), **caractérisée par le fait que** une piste (8) et/ou une structure de surface (17) et/ou une piste conductrice est/sont conçue(s) pour un échantillonnage inductif et/ou capacitif et/ou optique et/ou acoustique .

2. Le circuit imprimé selon la revendication 1, **caractérisé par le fait que** la denture (6, 12, 13) est fermée circonférentiellement et formée sur toute la surface de la surface circonférentielle (4).

3. Le circuit imprimé selon la revendication 1 ou 2, **caractérisé par le fait que** la denture (6, 12, 13) est conçue comme une denture en développante, épicycloïde ou hypocycloïde ou comme une denture en forme de lanterne .

4. Le circuit imprimé selon la revendication 3, **caractérisé par le fait que** la roue dentée (7, 10, 11, 16, 19) est conçue comme une croix de Malte.

5. Le circuit imprimé selon l'une des revendications précédentes, **caractérisé par le fait que** le circuit imprimé (1, 11) comporte au moins un des composants suivants : au moins une résistance électrique, au moins un condensateur, au moins une diode et/ou au moins un transistor.

6. Le circuit imprimé selon l'une des revendications précédentes, **caractérisé par le fait que** le circuit imprimé (1, 11) est fabriqué en plastique renforcé de fibres.

7. Le circuit imprimé selon l'une des revendications précédentes, **caractérisé par le fait que** la roue dentée (7, 10, 11, 16, 19) et/ou la denture (6, 12, 13) a/ont une structure de surface.

8. Le circuit imprimé selon l'une des revendications précédentes, **caractérisé par le fait que** la piste (8) et/ou la structure de surface (17) est/sont formée(s) par des saillies et des évidements.

9. Le circuit imprimé selon l'une des revendications précédentes, **caractérisé par le fait que** le circuit imprimé (1, 11) et/ou la denture (6, 12, 13) sont pourvus d'un revêtement contenant au moins du MoS₂ , du PTFE, du graphite ou de l'UHMWPE.

10. Le circuit imprimé selon l'une des revendications précédentes, **caractérisé par le fait que** la denture (6, 12, 13) est formée sur la surface circonférentielle extérieure.

11. Unité de capteur comportant une carte de circuit imprimé (1, 11) selon l'une des revendications précédentes 1 à 10.

12. Procédé de fabrication d'une carte de circuit imprimé selon l'une des revendications 1 à 10, dans lequel le procédé comprend l'étape suivante :
- former une denture sur la surface circonférentielle de la carte de circuit imprimé par fraisage, poinçonnage ou découpe au laser.

13. Le procédé selon la revendication 12, **caractérisé par le fait que** la denture (6, 12, 13) est formée circonférentiellement fermée sur toute la surface de la surface circonférentielle (4).

14. Le procédé selon la revendication 12 ou 13, **caractérisé par le fait que** la denture (6, 12, 13) est conçue comme une denture en développante, épicycloïde ou hypocycloïde ou comme une denture de lanterne.
